# EUROPEAN PATENT APPLICATION

(11) **EP 3 993 173 A1**
(43) Date of publication of application: **04.05.2022**
(21) Application number: 19952715.1
(22) Date of filing: 12.12.2019
(51) Int. Cl.: H01R 13/52, H01R 24/66, H01R 24/76

(54) **WATERPROOF JOINT AND WATER SPORTS DEVICE**

(30) Priority: 12.11.2019 CN 201911098025
(71) Applicant: Shenzhen Waydoo Intelligence Technology Co., Ltd., Shenzhen, Guangdong 518000 (CN)
(72) Inventor: ZHU, Qiuyang, Shenzhen, Guangdong 518000 (CN); ZHU, Weijie, Shenzhen, Guangdong 518000 (CN)
(74) Representative: Dr. Gassner & Partner mbB
(86) International application number: PCT/CN2019/124910
(87) International publication number: WO 2021/093071

(57) **Abstract**

Disclosed are a waterproof joint and a water sports device. The waterproof joint comprises: a first component on which a groove is formed; a first power connection part connected to the first component, at least part of the first power connection part being located in the groove; a second component on which an inserting part is provided, the inserting part being inserted into the groove; a second power connection part connected to the second component, at least part of the second power connection part being located on the insertion part; and a sealing member located between the inserting part and the groove when the inserting part is inserted into the groove and the first power connection part is electrically connected to the second power connection part.

## Description

### Cross-Reference to Related Application

This application claims priority to Chinese Patent Application No. 201911098025.9, filed to the China National Intellectual Property Administration on November 12, 2019 and entitled "WATERPROOF JOINT AND WATER SPORTS DEVICE", the disclosure of which is hereby incorporated by reference in its entirety.

### Technical Field

This application relates to the field of water sports, and in particular, to a waterproof joint and a water sports device.

### Background

With the development of science and technology, water sports devices such as electric surfboards have gradually become popular, and modular water sports devices have begun to appear. The so-called modular water sports device refers to a water sports device and is spliced by a driving module, a power module, and a surfboard module, which is intended to enhance assembly efficiency through the modular splicing, so as to simplify the assembly difficulty. However, in the related art, the driving module and the power module are mostly and electrically connected by using a common joint. Since the common joint is not waterproof, the joint must be placed in a waterproof cavity. In addition, since the joint needs to be located between the driving module and the power module, the waterproof cavity needs to be jointly formed by the driving module and the power module, which increases the structural complexity of the connection between the driving module and the power module, and is not conducive to rapid splicing between modules.

### Summary

This application resolves one of the technical problems in the related art at least to a certain extent. Therefore, this application provides a waterproof joint. A structure of a connection between modules can be simplified, and disassembly efficiency can be improved.

According to a first aspect, an embodiment of this application provides a waterproof joint. The waterproof joint includes a first component, a first power connection part, a second component, second power connection part, and a sealing member.

The first component is provided with a groove.

The first power connection part is connected to the first component, and at least part of the first power connection part is located in the groove.

The second component is provided with an inserting part, and a second power connection part is disposed on the inserting part and can be inserted in the groove.

The second power connection part is connected to the second component, and at least part of the second power connection part is located on the inserting part.

The sealing member is located between the inserting part and the groove when the inserting part is inserted in the groove and the first power connection part is connected to the second power connection part.

The waterproof joint in this embodiment of this application has at least the following technical effects: The inserting part is inserted in the groove. When the first power connection part is in contact with the second power connection part to achieve conduction, the sealing member achieves sealing between the first component and the second component, so that the first power connection part and the second power connection part can be sealed in a waterproof cavity. Since the waterproof cavity is formed between the first component and the second component, the joint achieves water resistance on the basis of conduction. Therefore, a structure of a connection between modules can be simplified, and rapid splicing between the modules can be realized. In addition, the structure realizes conducting and waterproofing by means of splicing, so that convenient usage is achieved, and disassembly efficiency is improved.

According to the waterproof joint in some embodiments of this application, an annular first sealing groove is formed in an outer sidewall of the inserting part in a circumferential direction of the inserting part, and the sealing member is connected to the outer sidewall through the first sealing groove.

Alternatively, an annular second sealing groove is formed in an inner sidewall of the groove in a circumferential direction of the groove, and the sealing member is connected to the inner sidewall through the second sealing groove.

According to the waterproof joint in some embodiments of this application, the first power connection part includes a conductive inserting needle extending from a bottom surface of the groove to an opening of the groove and a first conductive part extending from other walls on the first component different from a side in which the opening is located. The second power connection part includes a conductive socket extending from an end surface of the inserting part and a second conductive part extending from other walls on the second component different from a side at which the inserting part is located. The conductive inserting needle can be inserted in the conductive socket.

According to the waterproof joint in some embodiments of this application, the first conductive part is coaxial with the conductive inserting needle, and the second conductive part is coaxial with the conductive socket.

According to a second aspect, an embodiment of this application provides a water sports device.

The water sports device includes the above waterproof joint, a driving module, and a power module.

The driving module is in sealing connection with the first component, and at least the groove is located outside the driving module.

The power module is in sealing connection with the second component, and at least the inserting part is located outside the power module.

According to the water sports device in some embodiments of this application, the driving module includes a mounting box. A first mounting hole is disposed in the mounting box. The first component is in sealing connection with the first mounting hole by using a threaded fastener. The groove is exposed from the first mounting hole. The first conductive part is located in the mounting box.

According to the water sports device in some embodiments of this application, the mounting box is further provided with a second mounting hole. The driving module further includes a connecting rod. An end of the connecting rod is in sealing connection with the second mounting hole. A trace channel communicating with an inner cavity of the mounting box is disposed inside the connecting rod.

According to the water sports device in some embodiments of this application, the power module includes a power box. A mounting hole is disposed in the power box. The second component is in sealing connection with the mounting hole by using a threaded fastener. The inserting part is exposed from the mounting hole. The second conductive part is located in the power box.

According to the water sports device in some embodiments of this application, the water sports device further includes a sealing gasket. In a circumferential direction of the mounting hole, an annular flange is disposed on an inner wall of the power box. An upper edge of the flange is provided with an annular sealing groove in a circumferential direction. The sealing gasket includes a connecting part in sealing connection with an outer side of the second component and a sealing part embedded in the sealing groove.

According to the water sports device in some embodiments of this application, the first component is in sealing connection with a top of the driving module, and the second component is in sealing connection with a bottom of the power module.

### Brief Description of the Drawings

Fig. 1 is a schematic three-dimensional diagram showing a top of a first component according to a first embodiment of this application.
Fig. 2 is a schematic three-dimensional diagram of a second component according to a first embodiment of this application.
Fig. 3 is a schematic three-dimensional diagram of a water sports device according to a fourth embodiment of this application.
Fig. 4 is a schematic exploded view of Fig. 3.
Fig. 5 is a schematic three-dimensional diagram showing a bottom of a first component according to a fifth embodiment of this application.
Fig. 6 is a schematic three-dimensional diagram of a mounting box according to a fifth embodiment of this application.
Fig. 7 is a schematic three-dimensional diagram of a connection between a power box and a second component according to a seventh embodiment of this application.
Fig. 8 is a schematic exploded view in another direction of Fig. 7.

### Detailed Description of the Embodiments

This section will describe the embodiments of this application in detail. The embodiments of this application are shown in the accompanying drawings. The function of the accompanying drawings is to supplement the description of the text part of the specification with graphics, so that the description of each technical features and the overall technical solutions of the embodiments of this application can be understood intuitively and vividly, and should not be understood as limits to this application.

In the descriptions of this application, if an orientation description is involved, such as "up", "down", "front", "rear", "left", "right" and the like are orientation or position relationships shown in the drawings, are adopted not to indicate or imply that indicated devices or components must be in specific orientations or structured and operated in specific orientations but only to conveniently describe this application and simplify descriptions and thus should not be understood as limits to this application. If a feature is referred to be "set", "fixed", or "connected" to another feature, it can be directly set, fixed, or connected to another feature, or indirectly set, fixed, or connected to another feature.

In the description of the embodiments of this application, if it refers to "several", it means more than one; if it refers to "a plurality of", it means more than two; if it refers to "greater than", "less than", and "exceeding", it should be understood as not including the current number; and if it refers to "over", "below" and "within" should be understood as including the current number. If "first" and "second" are involved, it should be understood as used to distinguish technical features, but cannot be understood to indicate or imply relative importance or implicitly indicate the number of indicated technical features or implicitly indicate the precedence relation of the technical features.

In addition, unless otherwise defined, the technical and scientific terms used in the embodiments of this application have the same meanings as commonly understood by those skilled in the art. The terms used in this application are merely used to describe specific embodiments, not to limit this application.

### First embodiment

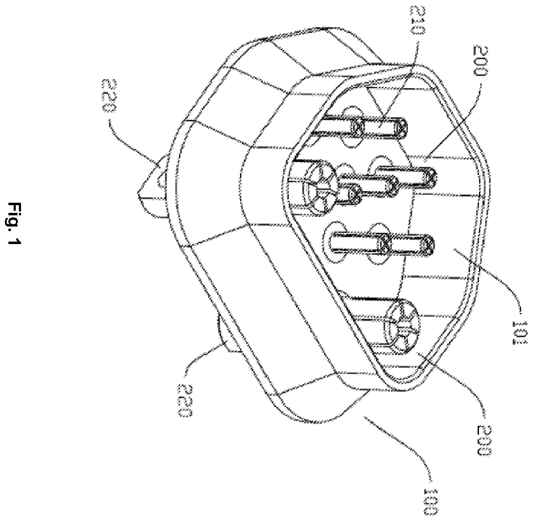

Fig. 1 shows a schematic three-dimensional diagram showing a top of a first component according to a first embodiment of this application. In this embodiment, a groove 101 is formed in the first component 100, and forms an opening in a top end surface of the first component 100. The first component 100 is further connected to a first power connection part 200. Specifically, the first power connection part 200 is located in the groove 101, and is configured to come into contact with an external conductive component to transmit electric energy.

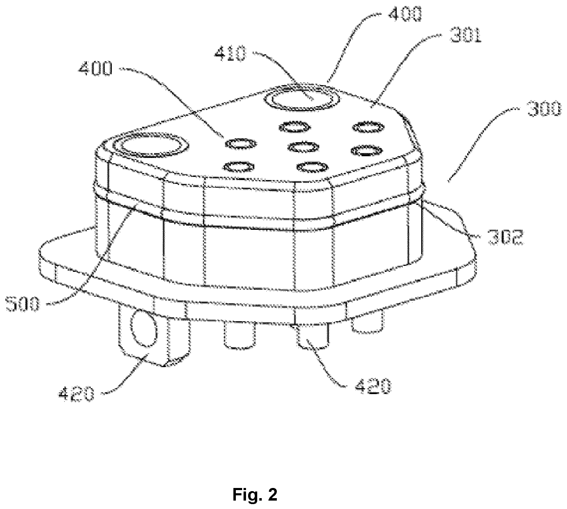

Fig. 2 is a schematic three-dimensional diagram of a second component according to a first embodiment of this application.

In this embodiment, a second component 300 is provided with an inserting part 301. The second component 300 is further connected to a second power connection part 400. Specifically, the second power connection part 400 is located on the inserting part 301, and is configured to come into contact with the external conductive component to transmit the electric energy.

In this embodiment, an annular first sealing groove 302 is formed in an outer sidewall of the inserting part 301 in a circumferential direction of the inserting part 301. The annular first sealing groove 302 is connected to a sealing member 500. In this embodiment, the sealing member 500 is an annular sealing ring. One part of the sealing ring is located in the first sealing groove 302, and the other part of the sealing ring extends from the first sealing groove 302. In this embodiment, during use, the inserting part 301 is inserted into the groove 101. The first power connection part 200 comes into contact with the second power connection part 400 to realize conduction. The sealing member 500 simultaneously bears against a sidewall of the groove 101 and a groove bottom of the first sealing groove 302 to form a sealing structure. Therefore, the first power connection part 200 and the second power connection part 400 can be sealed in a waterproof cavity. Since the waterproof cavity is formed between the first component 100 and the second component 300, a joint achieves water resistance on the basis of conduction. In this embodiment, by inserting the inserting part 301 into the groove 101, a guiding effect can also be achieved so that convenient docking of the first power connection part 200 and the second power connection part 400 is realized.

It can be understood that, in other embodiments, a connection position of the sealing member 500 can be changed. For example, an annular second sealing groove is formed in an inner sidewall of the groove 101 in a circumferential direction of the groove 101. The sealing member 500 is connected to the inner sidewall of the groove 101 through the second sealing groove. Therefore, the sealing between the first component 100 and the second component 300 can be realized as well.

### Second embodiment

Referring to Fig. 1 and Fig. 2, this embodiment is an improvement of the first embodiment. In this embodiment, a through hole (not shown in the figure) is formed in a bottom of the groove 101. The first power connection part 200 is inserted into the through hole at the bottom of the groove 101, and includes a conductive inserting needle 210 extending from a bottom surface of the groove 101 to an opening of the groove 101 and a first conductive part 220 extending from other walls on the first component 100 different from a side in which the opening of the groove 101 is located. The other walls described here may be sidewalls of the first component 100, or may be a bottom wall of the first component 100.

A through hole (not shown in the figure) is formed in the inserting part 301. The second power connection part 400 is inserted into the through hole in the inserting part 301, and includes a conductive socket 410 extending from an end surface of the inserting part 301 and a second conductive part 420 extending from other walls on the second component 300 different from a side in which the inserting part 301 is located. The other walls described here may be sidewalls of the second component 300, or may be a bottom wall of the second component 300.

In this embodiment, the conductive contact between the first power connection part 200 and the second power connection part 400 is to insert the conductive inserting needle 210 into the conductive socket 410. Therefore, the stable conduction between the power connection parts can be realized.

### Third embodiment

Referring to Fig. 1 and Fig. 2, this embodiment is an improvement on the basis of the second embodiment. In this embodiment, the first conductive part 220 is coaxial with the conductive inserting needle 210. The second conductive part 420 is coaxial with the conductive socket 410. Therefore, it may adapt to an assembly mode in which the water sports device is assembled sequentially in a single direction.

### Fourth embodiment

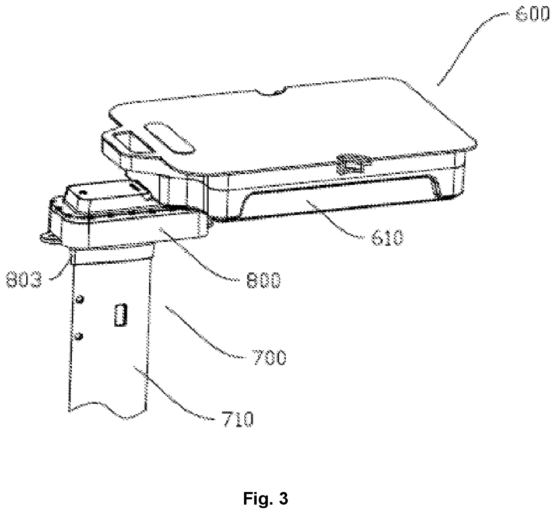

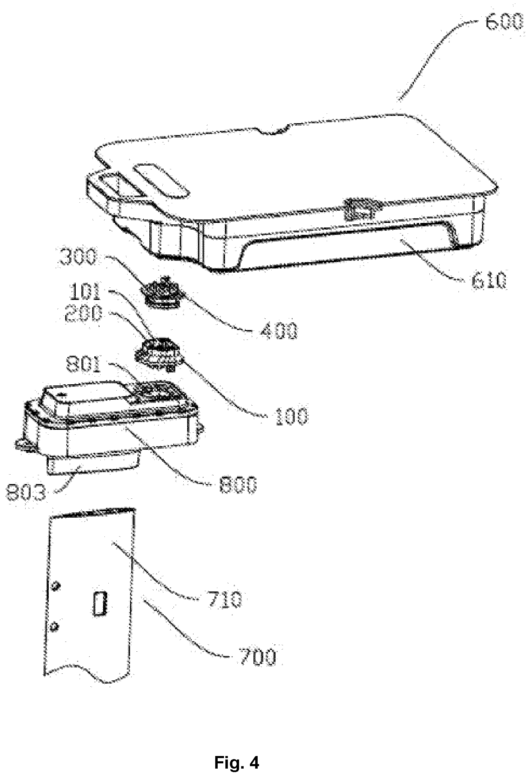

This embodiment discloses a water sports device. Referring to Fig. 3 and Fig. 4, Fig. 3 is a schematic three-dimensional diagram of a water sports device according to a fourth embodiment of this application, and Fig. 4 is a schematic exploded view of Fig. 3. In this embodiment, the water sports device includes a power module 600, a driving module 700, and the waterproof joint in the above various embodiments. The first component 100 is in sealing connection with the driving module 700, and at least the groove 101 is located outside the driving module 700. The second component 300 is in sealing connection with the power module 600, and at least the inserting part 301 is located outside the power module 600. In this way, through the connection between the first component 100 and the second component 300, water resistance can be achieved while conduction is realized, so that it is not necessary to form a waterproof cavity by means of the power module 600 and the driving module 700. Therefore, a structure of the connection between the power module 600 and the driving module 700 can be simplified, and rapid disassembly between modules can be achieved.

### Fifth embodiment

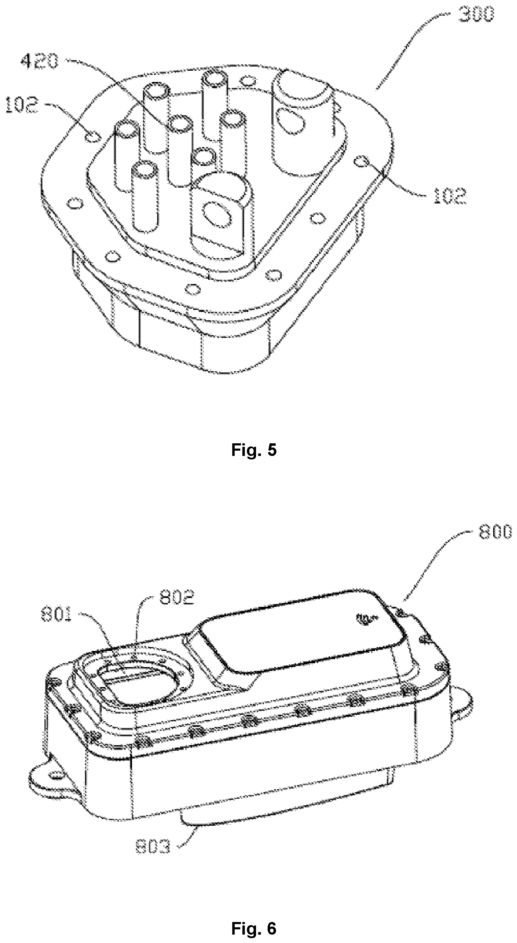

This embodiment is an improvement on the basis of the fourth embodiment. Referring to Fig. 5, Fig. 5 is a schematic three-dimensional diagram showing a bottom of a first component according to a fifth embodiment of this application. In this embodiment, a plurality of threaded holes 102 are formed in a bottom of the first component 100 in a circumferential direction. The threaded holes 102 are arranged densely.

In this embodiment, the water sports device further includes a mounting box 800. The mounting box 800 is configured to implement a connection between the first component 100 and the driving module 700. Referring to Fig. 6, Fig. 6 is a schematic three-dimensional diagram of a mounting box according to a fifth embodiment of this application. Atop of the mounting box 800 is provided with a first mounting hole 801. In a circumferential direction of the first mounting hole 801, a plurality of through holes 802 are formed in the mounting box 800. Positions and quantities of the through holes 802 correspond to the threaded holes 102.

Referring to Fig. 3 and Fig. 4, during connection, the first component 100 is located at the first mounting hole 801. A bottom end surface of the first component 100 bears against a top end surface of the mounting box 800, and is fastened by using a threaded fastener. In this case, the groove 101 is exposed from the first mounting hole 801, and the first conductive part 220 is located in the mounting box 800. Since the threaded holes 102 and the through holes 802 are arranged densely, the bottom end surface of the first component 100 can be tightly attached to the top end surface of the mounting box 800. In addition, a sealing gasket may be disposed between the first component 100 and the mounting box 800, so as to further increase sealing performance.

### Sixth embodiment

Referring to Fig. 3, Fig. 4, and Fig. 6, this embodiment is an improvement on the basis of the fifth embodiment. In this embodiment, a protruding part 803 is further disposed at a bottom of the mounting box 800. A bottom of the protruding part 803 is provided with a second mounting hole (not shown). The second mounting hole is communicated with an inner cavity of the mounting box 800.

In this embodiment, the driving module 700 further includes a connecting rod 710. The connecting rod 710 is configured to connect the mounting box 800 and a motor assembly which is not shown. In this embodiment, a top end of the connecting rod 710 is inserted in the second mounting hole. A trace channel is disposed in the connecting rod 710, and is communicated with the inner cavity of the mounting box 800 through the second mounting hole. Therefore, a lead connected to the first conductive part 220 may be connected to a motor by means of the trace channel, thereby realizing the transmission of the electric energy. A sealing connection between the connecting rod 710 and the mounting box 800 may adopt manners such as adhesive sealing, sealing ring sealing and the like.

### Seventh embodiment

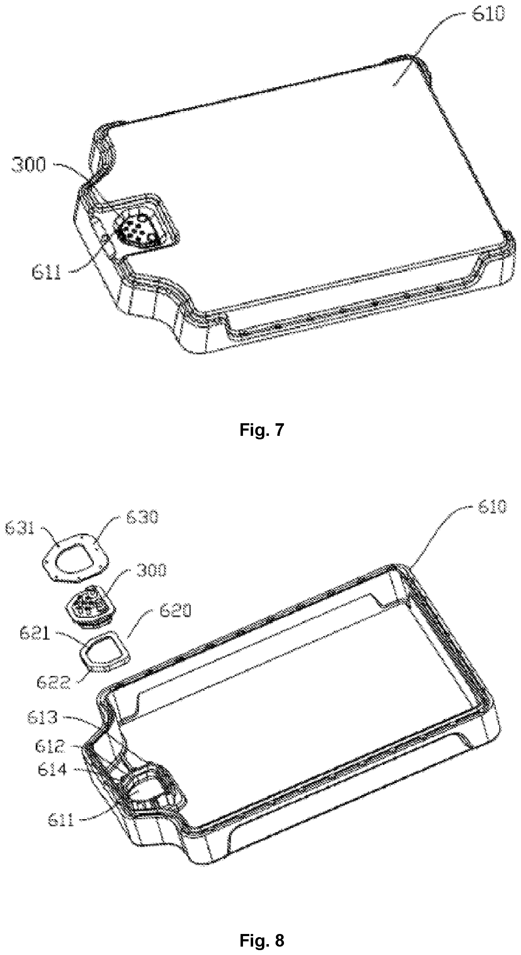

This embodiment is an improvement on the basis of the fourth embodiment. Referring to Fig. 7 and Fig. 8, Fig. 7 is a schematic three-dimensional diagram of a connection between a power box and a second component according to a seventh embodiment of this application. Fig. 8 is a schematic exploded view in another direction of Fig. 7. In this embodiment, the power module 600 includes a power box 610. A bottom of the power box 610 is provided with a mounting hole 611. In a circumferential direction of the mounting hole 611, an annular flange 612 is disposed on an inner wall of the power box 610. A circle of densely arranged connecting columns 613 having threaded holes are disposed outside the flange 612. A sealing groove 614 is formed inside the flange 612.

In this embodiment, a sealing gasket 620 is further disposed. The sealing gasket 620 includes a connecting part 621 and a sealing part 622. The connecting part 621 is tightly sleeved outside the second component 300 through elastic force. The sealing part 622 can be embedded in the sealing groove 614 to realize sealing.

In this embodiment, a pressing plate 630 is further disposed. A plurality of through holes 631 are formed in the pressing plate 630. Positions and quantities of the through holes 631 correspond to the connecting columns 613. During connection, the second component 300 is located in the mounting hole 611. The sealing gasket 620 is connected between the second component 300 and the flange 612. The pressing plate 630 is finally pressed on a top of the flange 612, and is fastened through a threaded fastener. Therefore, the second component 300 can be driven to squeeze the sealing gasket 620, so as to realize the sealing between the second component 300 and the power box 610.

### Eighth embodiment

This embodiment is an improvement on the basis of the fourth embodiment. Referring to Fig. 3 and Fig. 4, in this embodiment, the first component 100 is in sealing connection with a top of the driving module 700. The second component 300 is in sealing connection with a bottom of the power module 600. Therefore, after the power module 600 and the driving module 700 are connected by using the waterproof joint, a layout that the power module 600 is above and the driving module 700 is below is naturally formed, which is consistent with a service state of the water sports device. In this way, direct abutment between the modules can be achieved.

The embodiments of this application are described in detail above, but this application is not limited to the described embodiments. Those skilled in the art can make various equivalent modifications or replacements without departing from the spirit of this application. These equivalent modifications or replacements all fall in the scope defined by the claims of this application. In addition, in the case of no conflict, the embodiments of this application and the features in the embodiments may be combined with one another.

## Claims

1. A waterproof joint, comprising:
a first component, provided with a groove;
a first power connection part, connected to the first component, at least part of the first power connection part being located in the groove;
a second component, provided with an inserting part, a second power connection part being disposed on the inserting part, and being able to be inserted in the groove;
the second power connection part, connected to the second component, at least part of the second power connection part being located on the inserting part; and
a sealing member, located between the inserting part and the groove when the inserting part is inserted in the groove and the first power connection part is connected to the second power connection part.

2. The waterproof joint as claimed in claim 1, wherein an annular first sealing groove is formed in an outer sidewall of the inserting part in a circumferential direction of the inserting part, and the sealing member is connected to the outer sidewall through the first sealing groove; alternatively
an annular second sealing groove is formed in an inner sidewall of the groove in a circumferential direction of the groove, and the sealing member is connected to the inner sidewall through the second sealing groove.

3. The waterproof joint as claimed in claim 2, wherein the first power connection part comprises a conductive inserting needle extending from a bottom surface of the groove to an opening of the groove and a first conductive part extending from other walls on the first component different from a side in which the opening is located, the second power connection part comprises a conductive socket extending from an end surface of the inserting part and a second conductive part extending from other walls on the second component different from a side at which the inserting part is located, and the conductive inserting needle is inserted in the conductive socket.

4. The waterproof joint as claimed in claim 1, wherein the first power connection part comprises a conductive inserting needle extending from a bottom surface of the groove to an opening of the groove and a first conductive part extending from other walls on the first component different from a side in which the opening is located, the second power connection part comprises a conductive socket extending from an end surface of the inserting part and a second conductive part extending from other walls on the second component different from a side at which the inserting part is located, and the conductive inserting needle is inserted in the conductive socket.

5. The waterproof joint as claimed in claim 4, wherein the first conductive part is coaxial with the conductive inserting needle, and the second conductive part is coaxial with the conductive socket.

6. A water sports device, comprising:
a driving module, in sealing connection with the first component, at least the groove being located outside the driving module; and
a power module, in sealing connection with the second component, at least the inserting part being located outside the power module.

7. The water sports device as claimed in claim 6, wherein a waterproof joint comprises:
a first component, provided with a groove;
a first power connection part, connected to the first component, at least part of the first power connection part being located in the groove;
a second component, provided with an inserting part, a second power connection part being disposed on the inserting part, and being able to be inserted in the groove;
the second power connection part, connected to the second component, at least part of the second power connection part being located on the inserting part; and
a sealing member, located between the inserting part and the groove when the inserting part is inserted in the groove and the first power connection part is connected to the second power connection part.

8. The water sports device as claimed in claim 7, wherein an annular first sealing groove is formed in an outer sidewall of the inserting part in a circumferential direction of the inserting part, and the sealing member is connected to the outer sidewall through the first sealing groove; alternatively
an annular second sealing groove is formed in an inner sidewall of the groove in a circumferential direction of the groove, and the sealing member is connected to the inner sidewall through the second sealing groove.

9. The water sports device as claimed in claim 8, wherein the first power connection part comprises a conductive inserting needle extending from a bottom surface of the groove to an opening of the groove and a first conductive part extending from other walls on the first component different from a side in which the opening is located, the second power connection part comprises a conductive socket extending from an end surface of the inserting part and a second conductive part extending from other walls on the second component different from a side at which the inserting part is located, and the conductive inserting needle is inserted in the conductive socket.

10. The water sports device as claimed in claim 7, wherein the first power connection part comprises a conductive inserting needle extending from a bottom surface of the groove to an opening of the groove and a first conductive part extending from other walls on the first component different from a side in which the opening is located, the second power connection part comprises a conductive socket extending from an end surface of the inserting part and a second conductive part extending from other walls on the second component different from a side at which the inserting part is located, and the conductive inserting needle is inserted in the conductive socket.

11. The water sports device as claimed in claim 10, wherein the first conductive part is coaxial with the conductive inserting needle, and the second conductive part is coaxial with the conductive socket.

12. The water sports device as claimed in claim 7, wherein the driving module comprises a mounting box, a first mounting hole is disposed in the mounting box, the first component is in sealing connection with the first mounting hole by using a threaded fastener, the groove is exposed from the first mounting hole, and the first conductive part is located in the mounting box.

13. The water sports device as claimed in claim 6, wherein the driving module comprises a mounting box, a first mounting hole is disposed in the mounting box, the first component is in sealing connection with the first mounting hole by using a threaded fastener, the groove is exposed from the first mounting hole, and the first conductive part is located in the mounting box.

14. The water sports device as claimed in claim 13, wherein the power module comprises a power box, a mounting hole is disposed in the power box, the second component is in sealing connection with the mounting hole by using a threaded fastener, the inserting part is exposed from the mounting hole, and the second conductive part is located in the power box.

15. The water sports device as claimed in claim 13, wherein the first component is in sealing connection with a top of the driving module, and the second component is in sealing connection with a bottom of the power module.

16. The water sports device as claimed in claim 13, wherein the mounting box is further provided with a second mounting hole, the driving module further comprises a connecting rod, an end of the connecting rod is in sealing connection with the second mounting hole, and a trace channel communicating with an inner cavity of the mounting box is disposed inside the connecting rod.

17. The water sports device as claimed in claim 6, wherein the power module comprises a power box, a mounting hole is disposed in the power box, the second component is in sealing connection with the mounting hole by using a threaded fastener, the inserting part is exposed from the mounting hole, and the second conductive part is located in the power box.

18. The water sports device as claimed in claim 17, wherein the first component is in sealing connection with a top of the driving module, and the second component is in sealing connection with a bottom of the power module.

19. The water sports device as claimed in claim 17, further comprising a sealing gasket, in a circumferential direction of the mounting hole, an annular flange is disposed on an inner wall of the power box, an upper edge of the flange is provided with an annular sealing groove in a circumferential direction, and the sealing gasket comprises a connecting part in sealing connection with an outer side of the second component and a sealing part embedded in the sealing groove.

20. The water sports device as claimed in claim 6, wherein the first component is in sealing connection with a top of the driving module, and the second component is in sealing connection with a bottom of the power module.
